# EUROPEAN PATENT APPLICATION

(11) **EP 4 780 152 A1**
(43) Date of publication of application: **22.07.2026**
(21) Application number: 25152145.6
(22) Date of filing: 16.01.2025
(51) Int. Cl.: H05K 7/20

(54) **COOLING BLOCK FOR COOLING OF AN ELECTRONIC COMPONENT**

(71) Applicant: Connaught Electronics Ltd., County Galway H54 Y276 (IE)
(72) Inventor: KRISHNAMOORTHI, Preethkumar, 600130 Chennai (IN); DEEPAKARAN, Harish, 600130 Chennai (IN); RANA, Gyana-Ranjan, 600130 Chennai (IN); TROUT, Shane, Tuam, H54 Y276 (IE)
(74) Representative: Jauregui Urbahn, Kristian

(57) **Abstract**

Cooling block (1) for cooling an electronic component (5) of an electronic computing device (10) of a motor vehicle (15). The cooling block (1) is applicable to a cooling channel (6) for guiding a cooling fluid. The cooling block (1) comprises an inlet side (2) on a first side of the cooling block (1) and an outlet side (3) on a second side of the cooling block (1). Additionally the cooling block (1) comprises a through hole (4a, 4b, 4c, 4d, 4') connecting the inlet side (2) to the outlet side (3) of the cooling block (1). The through hole (4a, 4b, 4c, 4d, 4') goes along a helical path through the cooling block (1).

## Description

The invention relates to a cooling block for cooling an electronic component of an electronic computing device of a motor vehicle. The invention also relates to an electronic computing device with such a cooling block as well as to a motor vehicle with such an electronic computing device.

A motor vehicle typically comprises at least one electronic computing device with an electronic component. Particularly in connection with at least partially automated vehicles, there is a high power requirement of the electronic computing device, which means that cooling of the electronic component of the electronic computing device is becoming increasingly relevant. Passive cooling systems are often not able to cool the electronic computing device sufficiently. For this reason, active cooling systems are particularly relevant, in which a cooling fluid, such as a cooling liquid, is guided through a cooling channel of an electronic computing device in order to quickly and reliably dissipate heat generated by the electronic component.

In computing and electronics, such as the electronic computing device, different methods of cooling the assembled electronic components are known. Especially for powerful components and for example for small installation spaces, the traditional air cooling systems are not sufficient. In such cases heat, which is generated during operation of the assembled electronic components, may for example be dissipated by a cooling fluid. As the electronic component may not be designed to get in direct contact with the cooling fluid, a housing may be introduced to guide the cooling fluid in close proximity of the electronic component and establish a thermal connection to it. The housing may also comprise a cooling channel for guiding the cooling fluid. Especially for electronic computing devices with different electronic components the challenge might be to reach the individual electronic components, which generate the highest amount of heat and maximize the heat transfer in these regions.

It is an objective of the present invention to provide a solution by means of which an electronic component of an electronic computing device may be cooled with high cooling efficiency.

The objective is achieved by the subject matter of the independent claims. Further implementations and preferred embodiments are a subject matter of the dependent claims.

The invention is based on the idea, that the cooling fluid may dissipate the generated heat better, if the structure, which is guiding it, offers an improved thermal contact to the electronic component via a cooling block, which is placed inside a cooling channel and comprises a helical through hole.

According to an aspect of the invention, a cooling block for cooling an electronic component of an electronic computing device of a motor vehicle is provided. The cooling block is applicable to a cooling channel for guiding a cooling fluid. Furthermore, the cooling block comprises an inlet side on a first side of the cooling block and the cooling block comprises an outlet side on a second side of the cooling block. In addition, the cooling block comprises a through hole connecting the inlet side to the outlet side of the cooling block. Moreover, the through hole goes along a helical path through the cooling block or, in other words, follows a helical path through the cooling block.

In particular, the inlet side may correspond to the first side and the outlet side may correspond to the second side of the cooling block.

In other words, the cooling block may allow the cooling fluid to flow through the cooling block from the inlet side to the outlet side taking the helical path. The second side of the cooling block may for example be a different side from the first side of the cooling block. That the cooling block is applicable to the cooling channel may be understood such that the cooling block may be inserted in the cooling channel in a direction of flow of the cooling fluid in such a way, that the cooling fluid may enter the cooling block at the inlet side and exit the cooling block at the outlet side. In some embodiments, the cooling block, in particular its outer shape, may be reflectively symmetrical with respect to a plane parallel to the inlet side or to the outlet side and thus the placement of the cooling block in the cooling channel may be independent of the flow direction, especially the cooling fluid may also enter the cooling block at the outlet side and exit at the inlet side in principle.

The helical path may be described as a shape like a cylindrical coil spring or a thread of a machine screw. It is for example a type of smooth space curve with tangent lines at a constant angle to a fixed axis. If projected to the inlet side or to the outlet side, the helical path may be a circle in case the fixed axis runs perpendicular to the inlet side or the outlet side respectively. Then a position of the fixed axis may be a center of the circle. Alternatively, the helical path may be a spiral if projected to the inlet side or to the outlet side respectively. The through hole may for example comprise a centerline with a helical course and a constant or variable diameter perpendicular to the centerline.

The heat of the electronic component, which may for example be placed in direct proximity of the cooling block and may be in thermal contact with the cooling block, may be dissipated by means of a heat transport with the cooling fluid. It may be provided that there is no direct mechanical contact between the cooling block and the electronic component, but a thermal contact via a housing, the cooling channel, an additional cooling device or the like. In other embodiments, there may be a direct mechanical contact between the cooling block and the electronic component. The cooling channel may also be referred to as a heat sink or the like.

The cooling fluid may comprise a liquid coolant, such as for example water, oil, or special cooling liquids for cooling electronic systems. The cooling fluid may also be gaseous, such as air or special gases for cooling electronic systems.

An advantage of the cooling block according to the invention is the improved heat dissipation of the generated heat and thus a stable operation of electronic components, which might generate large amounts of heat. With the introduced invention, a more powerful electronic component may be integrated in a motor vehicle without having a risk of overheating the respective component or degrading the lifetime of the component.

By inserting the cooling block in the cooling channel, for example, the through hole locally in the section of the cooling block increases a flow velocity of the cooling fluid compared to a cooling channel without a cooling block. This increases the heat transport by convection. The electronic component may therefore be cooled with high cooling efficiency using the cooling block.

The helical path increases a distance, which the cooling fluid has to overcome from the inlet side to the outlet side compared to a linear or straight path. Thus, a surface along the distance is longer and the flow velocity is higher for the helical path compared to the linear or straight path. This will have a positive influence on the cooling efficiency.

According to at least one embodiment, the cooling block may consist of one piece or of several pieces, which may be assembled subsequently to the manufacturing process of each of the several pieces.

According to at least one embodiment, the cooling block comprises or consists of a thermally conductive material, for example a metal, which may enhance the heat dissipation. The through hole may be designed for guiding the cooling fluid.

According to at least one embodiment, the through hole corresponds to a recess from the die-casting process in case the cooling block is a die-casted part or any subsequently generated cavity, for example a machined or drilled hole. The through hole may also be referred to as a mini-channel or a micro-channel in comparison to the cooling channel, which may for example comprise a larger cavity in order to at least partly enclose the cooling channel. The cooling block may also be produced in a 3D printing process or a metal 3D printing process.

According to at least one further embodiment, the dimensions of the cooling block may be for example in the range of 20 mm to 100 mm in each direction with a typical value of 50 mm. Therein the dimensions in each direction may vary.

According to at least one embodiment, the cooling block is of a cuboid shape or an irregular shape. The irregular shape may be adapted to the cooling channel, which it may be designed for, and optimized for inserting into the cooling channel.

According to at least one embodiment, a hole diameter of the through hole may for example be in the range of 1 mm to 6 mm, with a typical value of 2 mm.

According to at least one further embodiment, an outer shape of the cooling block is a cuboid shape or an essentially cuboid shape and the first side represents a first side face of the cuboid shape and the second side represents a second side face of the cuboid shape.

In other words, the first side and the second side may be plane or approximately plane. In particular, the first side and the second side may be parallel to each other or perpendicular to each other.

For example, the cuboid shape may be a rectangular cuboid shape. In this case the inlet side and the outlet side may be parallel to each other. Especially the cuboid shape may also be a cube shape in some embodiments.

An advantage of the cuboid shape of the cooling block is an easy manufacturing process and a flexible assembly within the cooling channel.

According to at least one further embodiment the cooling block comprises a first additional through hole connecting the inlet side to the outlet side of the cooling block.

The through hole and the first additional through hole may be placed next to each other on the inlet side or on the outlet side. The cooling fluid may be able to flow through the through hole as well as through the first additional through hole from the inlet side to the outlet side or vice versa. A hole diameter of the first additional through hole may be in the same range as the hole diameter of the through hole, or the hole diameters may be identical. Alternatively the hole diameter of the first additional through hole may be larger or smaller than the hole diameter of the through hole.

An advantage of the first additional through hole is a higher throughput of the cooling fluid and thus an increased heat transport of the cooling block.

According to at least one further embodiment the first additional through hole goes along a linear path through the cooling block and the helical path of the through hole winds around the linear path.

An advantage of this embodiment is the effective usage of a volume of the cooling block. The cooling fluid can flow through a compact area of the inlet side to the outlet side. The heat transport is enhanced while reducing an additional pressure loss of the cooling block within the cooling channel.

The linear path may for example be a straight path. In case the inlet side is parallel to the outlet side, the straight path may run perpendicular to the inlet side or to the outlet side.

For example, a center of the first additional through hole is located within a projection of the helical path of the through hole to the inlet side and/or to the outlet side, for example in a center of the projection.

According to at least one further embodiment the first additional through hole goes along a first additional helical path through the cooling block.

The first additional helical path may have similar or identical characteristic as the helical path. Alternatively, the first additional helical path may vary in terms of a diameter of the projection on the inlet side or on the outlet side. The first additional helical path may also vary in terms of a winding distance, which may be a distance of one winding to the next at an identical rotation angle.

An advantage of the first additional helical path is the enhanced cooling transport of the dissipated heat.

According to at least one further embodiment the helical path and the first additional helical path each wind around a common centerline forming an interlocking double helix.

A geometric shape of the helical path and a geometric shape of the first additional helical shape may be identical except for a position of the through hole compared to a position of the first additional through hole on the inlet side. The position of the first additional through hole may be rotated around the common centerline by a rotation angle starting at the position of the through hole. For example, the rotation angle may be 180°.

The winding distance of the helical path and the first additional helical path may for example be identical. For example, the winding distance is equal or greater than the hole diameter of the through hole and the hole diameter of the first additional through hole.

An advantage of the interlocking double helix is the compact construction and the large area of an inner surface of the cooling block. The inner surface of the cooling block may be the sum of an inner surface of a mini-channel created by the through hole and a first additional mini-channel created by the first additional through hole.

According to at least one further embodiment, the cooling block comprises two or more second additional through holes each connecting the inlet side to the outlet side of the cooling block.

The through hole and the two or more second additional through holes and, as far as provided, the first additional through hole may be placed next to each other on the inlet side or on the outlet side. The cooling fluid may be able to flow through the through hole, the first additional through hole, if applicable, as well as through the two or more second additional through holes from the inlet side to the outlet side or vice versa. A hole diameter of the two or more second additional through holes may be in the same range as the hole diameter of the through hole or of the first additional through hole, or the hole diameters may be identical. Alternatively the hole diameter of the two or more second additional through holes may be larger or smaller than the hole diameter of the through hole or of the first additional through hole.

An advantage of the two or more second additional through holes is a higher throughput of the cooling fluid and thus an increased heat transport of the cooling block.

According to at least one further embodiment each of the two or more second additional through holes goes along a respective second additional helical path through the cooling block and the helical path and each second additional helical path wind around a common centerline, forming an interlocking multiple helix.

For example the common centerline of the interlocking multiple helix may also be the position for the first additional through hole. In this case the first additional through hole may go along the linear path from the inlet side to the outlet side, especially it may go along the straight path.

The geometric shape of the helical path and a geometric shape of each second additional helical shape may be identical except for the position of the through hole compared to a position of each of the two or more second additional through holes on the inlet side.

Starting at the position of the through hole, each position of the two or more second additional through holes may for example be rotated around the common centerline by a multiple of a second rotation angle. For example, the second rotation angle may be 90°, if a number of the two or more additional through holes is exactly three. The interlocking multiple helix may especially be an interlocking quadruple helix.

The winding distance of the helical path and each of the second additional helical path may for example be identical. The interlocking multiple helix may require, that the winding distance is equal or greater than the hole diameter of the through hole and a hole diameter of the two or more second additional through holes.

An advantage of the interlocking multiple helix is the compact construction and the large area of an enhanced inner surface of the cooling block. The enhanced inner surface of the cooling block may be the sum of the inner surface of the mini-channel created by the through hole, the first additional mini-channel created by the first additional through hole and the two or more second additional mini-channels created by the two or more second additional through holes.

According to at least one further embodiment the cooling block comprises copper and/or copper alloy and/or aluminum and/or aluminum alloy.

The cooling block may for example consist of copper and/or copper alloy and/or aluminum and/or aluminum alloy.

An advantage of this embodiment is the easy manufacturing process and the superior thermal conductivity of copper, copper alloy, aluminum and aluminum alloy.

A further aspect of the invention relates to a cooling block array comprising at least two cooling blocks according to the invention. Each respective first side of the at least two cooling blocks is parallel to all other respective first sides of the at least two cooling blocks. In addition, the at least two cooling blocks are thermally connected to each other.

The cooling block array may be designed in one piece. Thus, the at least two cooling blocks may be geometrical parts of one single unit and may especially not be mechanically separable without destroying the cooling block array. In alternative embodiments, the cooling block array may also be a joined part consisting of individual at least two cooling blocks. The at least two cooling blocks may in this case be joined for example with an adhesive process or welded in order to form the cooling block array.

The at least two cooling blocks may be in thermal contact to each other as well as in thermal contact to the electronic component.

An advantage of the cooling block array is the high heat load that can be transported away from the electronic component. The throughput of the cooling fluid may be high and enable an intensive cooling process.

By inserting the cooling block array in the cooling channel, for example, the flow velocity of the cooling fluid is high, while at the same time the amount of cooling fluid is increased compared to a single cooling block. The electronic component may therefore be cooled with high cooling efficiency using the cooling block array.

A further aspect of the invention relates to an electronic computing device for a motor vehicle comprising a housing and an electronic component. The housing comprises or forms a cooling channel for guiding a cooling fluid. The housing also comprises a cooling block according to the invention or a cooling block array according to the invention. The cooling block or the cooling block array is located in the cooling channel and the electronic component is thermally connected to the cooling block or the cooling block array.

The housing may comprise or consist of a metal such as aluminum or aluminum alloy. It may for example also comprise or consist of a plastic compound material. The housing may for example form the cooling channel as a recess in a first housing side. Alternatively, the cooling channel may also be a separate part, which can be assembled to the housing.

The housing may for example comprise an inlet connection in order to supply the housing with the cooling fluid. The cooling channel may receive the cooling fluid from the housing or directly from the inlet connection. The cooling fluid may be able to flow through the cooling channel and thus through the cooling block from the inlet side to the outlet side or through the cooling block array. Additionally the cooling fluid may exit the cooling channel. The cooling fluid may subsequently exit the housing for example via an outlet connection. Alternatively, the cooling fluid may flow through the electronic computing device in an opposite direction.

A thermal contact between the electronic component and the cooling block or the cooling block array may be achieved for example by transmitting the heat via a thermally conductive part of the housing and/or the cooling channel. The electronic component may for example be placed within the housing.

The inlet connection may for example be connected to a source for providing the cooling fluid wherein the source is arranged separately to the electronic computing device in the motor vehicle. Furthermore, the outlet connection may for example be connected to a corresponding drain for the cooling fluid, wherein the drain is also arranged externally to the electronic computing device in the motor vehicle. The motor vehicle may, for example, comprise means for recirculating or conditioning or re-cooling of the cooling fluid received by the drain from the outlet connection and provided again via the source to the inlet connection. To this end, the motor vehicle may also comprise a transportation system for the cooling fluid including, for example, one or more pumps to convey the cooling fluid from the source to the inlet connection through the housing back to the outlet connection and the drain and so forth.

Consequently, the supply of the electronic computing device with the cooling fluid may be implemented in a particularly compact way by providing the housing according to the invention. The electronic computing unit may be placed within the motor vehicle in various places as it may be largely protected from environmental influences.

According to at least one embodiment the electronic computing device may for example comprise an electronic computing unit (ECU), a zonal controller unit (ZCU) or a domain controller unit (DCU). According to at least one embodiment, it is provided that the electronic computing device is part of a vehicle-centric, zone-oriented architecture of electrical and/or electronic components of the motor vehicle.

In particular, at least one main controller, for example a single main controller, may be provided in the vehicle architecture, which may also be referred to as the main control unit or vehicle computer, and which may be designed to perform main computing operations for vehicle-specific applications, for example autonomous driving and/or driver assistance functions.

The main controller may be connected to several, for example two to six, in particular four, zonal controllers, which may also be referred to as zone controllers or zonal control units, ZCUs, by means of a wired and/or wireless communication technology. Zonal controllers may be designed to perform less demanding computing operations compared to the main computing operations of the main controller.

For example, the electronic vehicle architecture can be divided into zones, for example four zones, wherein a zonal controller can be provided for each of the zones. In particular, the main controller can be connected via the zonal controllers to other electrical and/or electronic components of the motor vehicle, in particular to smaller, distributed control units, sensors and/or actuators of the motor vehicle.

Such a vehicle-centric, zone-oriented architecture of the electrical or electronic components can be beneficial since it may be less complex than a domain-oriented architecture. In particular, the computing operations of the complex, vehicle-specific applications of distributed control units can be consolidated on a single or on a few, very powerful main controllers.

For example, the electronic computing device according to the invention may be a main controller of the motor vehicle. Alternatively, the electronic computing device according to the invention may be a zonal controller of the motor vehicle or a domain controller of the motor vehicle.

According to at least one further embodiment the electronic component comprises a system-on-chip and/or a system-in-package.

The system-on-chip may be an integrated circuit that integrates most or all components of a computer or other electronic system. The system-on-chip may for example comprise an on-chip central processing unit (CPU), memory interfaces, input/output devices and interfaces, and secondary storage interfaces, often alongside other components such as radio modems and a graphics processing unit (GPU).

The system-in-package may for example comprise a number of integrated circuits enclosed in one chip carrier package. The system-in-package may for example include passive components and perform the functions of an entire system. The number of integrated circuits may be stacked using package on package, placed side by side, and/or embedded in a substrate.

Both the system-on-chip and the system-in-package may feature a high computing power, which may for example result in a high heat dissipation respectively.

An advantage of described electronic components is a high integration density and at the same time an effective cooling mechanism within the electronic computing device.

According to at least one further embodiment, a thermal conductivity of the cooling block and/or the cooling block array is greater or at least equal to a thermal conductivity of cooling channel walls spatially limiting the cooling channel.

If the cooling channel is part of the housing, the cooling channel walls may be part of the housing as well. A shape of the cooling channel walls may for example be designed to guide the cooling fluid through the cooling channel. Especially, the cooling channel walls are in direct contact with the cooling fluid. The shape of the cooling channel walls may be designed to at least partly enclose the cooling block and/or the cooling block array.

When assembled to the cooling channel, the cooling block and/or the cooling block array may be fixed in a position with the cooling channel. The dynamic behavior of the cooling fluid may not influence the position of the cooling block and/or the cooling block array.

An advantage of this embodiment is a concentration of effective cooling at the cooling block and/or at the cooling block array. By selective assembly of the cooling block and/or the cooling block array within the cooling channel a highest cooling power can be located at desired positions.

According to at least one further embodiment, the housing comprises a cover and the cover is attached to the cooling channel, wherein the cover seals the cooling channel in a fluid-tight manner and the electronic component and the cooling block are arranged on opposite sides of the cooling channel.

Especially the fluid-tight manner may be related to all sides of the cover and the cooling channel except for the first spigot connection and the second spigot connection. In an assembled status the cooling fluid may for example be able to flow from the first spigot connection through the housing to the second spigot connection or vice versa.

Fluid-tight may be understood as watertight and/or airtight, especially tight to the cooling fluid.

The housing may also comprise the first housing side and a second housing side. The combination of the cover and the cooling channel may be enclosed by the first housing side and the second housing side.

The cooling block may be attached to a first side of the cooling channel. The electronic component may for example be attached to a second side of the cooling channel, which may not be in direct contact with the cooling fluid.

An advantage of this embodiment is a compact design, which enables thermal contact from the electronic component to the cooling fluid, but at the same time protects the electronic component from direct contact to fluids.

A further aspect of the invention relates to a motor vehicle comprising an electronic computing device according to the invention.

In some implementations, the motor vehicle may comprise the source and/or the drain for the cooling fluid and, for example, the transportation system for supplying the electronic computing device with the cooling fluid and for draining the cooling fluid from the electronic computing device.

Further features of the invention are evident from the claims, the figures, and the description of the figures. The features and feature combinations previously mentioned in the description as well as the features and the feature combinations mentioned in the following in the description of the figures and/or shown in the figures may be contained by the invention not only in the respective indicated combination, but also in other combinations. In particular, embodiments and feature combinations, which do not comprise all features of an originally formulated claim, are also comprised by the invention. Moreover, embodiments and feature combinations, which go beyond the feature combinations set out in the recitations of the claims or deviate from these, are comprised by the invention.

In the following the invention is explained in detail with regard to special exemplary implementations and respective schematic drawings. In the drawings, identical or functionally identical elements may be equipped with the same reference signs. The description of identical or functionally identical elements is not necessarily repeated with regard to various figures.

In the figures:
- Fig. 1: shows a schematic representation of an exemplary implementation of a cooling block within a cooling channel according to the invention;
- Fig. 2: shows a perspective view of an exemplary implementation of a cooling block array according to the invention;
- Fig. 3: shows a front view of a further exemplary implementation of a cooling block array according to the invention;
- Fig. 4: shows a schematic representation of a further exemplary implementation of a cooling block array according to the invention within a cooling channel;
- Fig. 5: shows a perspective view of an exemplary implementation of an electronic computing device according to the invention;
- Fig. 6: shows an explosion view of the electronic computing device of Fig. 5; and
- Fig. 7: shows a schematic representation of an exemplary implementation of a motor vehicle according to the invention.

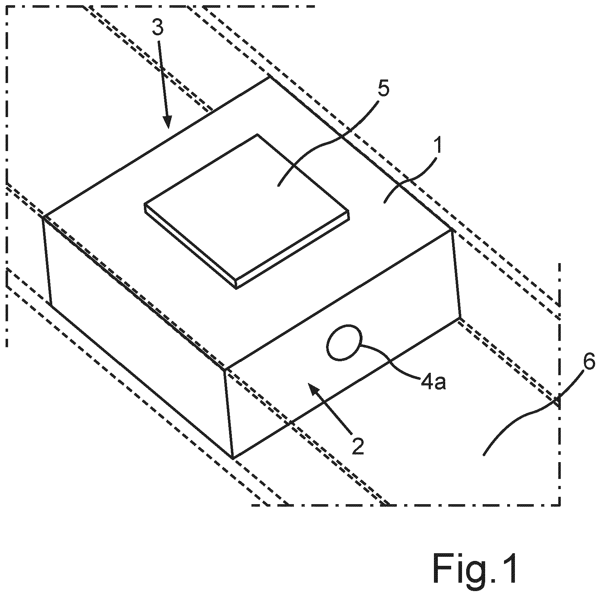

Fig. 1 shows schematically a cooling block 1 for cooling an electronic component 5 of an electronic computing device 10 of a motor vehicle 15 according to the invention. The cooling block 1 is applicable to a cooling channel 6 for guiding a cooling fluid. In Fig. 1, an example of this assembly is shown. The cooling block 1 comprises an inlet side 2 on a first side of the cooling block 1 and an outlet side 3 on a second side of the cooling block 1. Additionally, the cooling block 1 comprises a through hole 4a connecting the inlet side 2 to the outlet side 3 of the cooling block 1. The through hole 4a goes along a helical path (not shown in Fig. 1) through the cooling block 1.

The cooling channel 6 may enclose the cooling block 1 at least partially, so that the cooling fluid may flow through the cooling channel 6 and may be forced to flow through the cooling block 1. The cooling fluid may flow through the through hole 4afrom the inlet side 2 to the outlet side 3. The electronic component 5 may for example be placed directly next to the cooling block 1 or be placed in a thermic surrounding of the cooling block 1 so that the electronic component 5 is thermally connected to the cooling block 1.

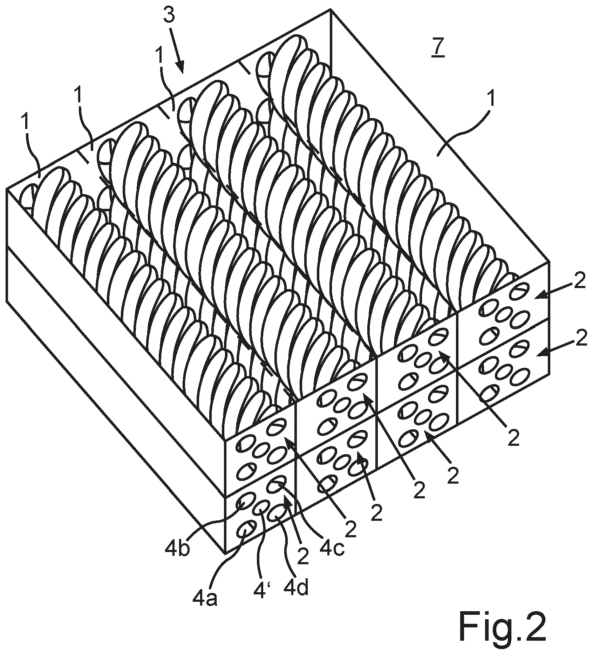

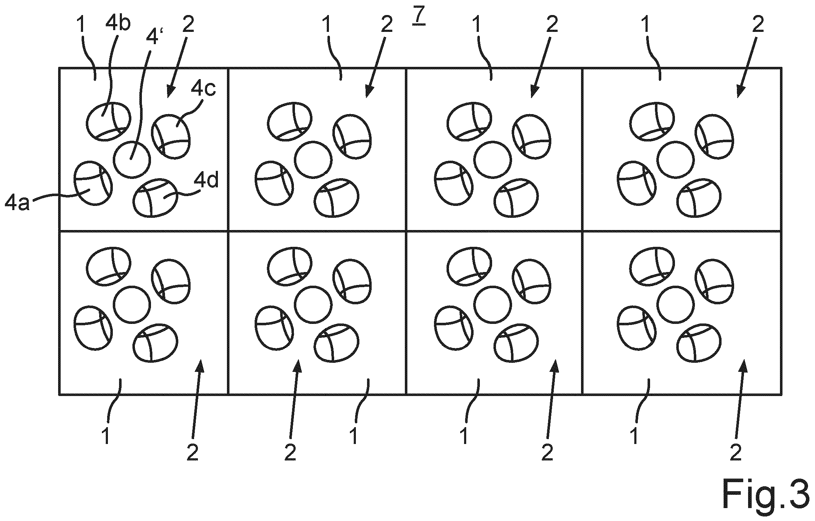

Fig. 2 and Fig. 3 show an implementation of the cooling block array 7 according to the invention. The cooling block array 7 may comprise at least two cooling blocks 1, which are connected to each other. In this example the cooling block array 7 consists of eight cooling blocks 1. Each cooling block 1 may be a geometric unit, but is not necessarily an individual part. The cooling block array 7 may be one single part. Each inlet side 2 of the at least two cooling blocks 1 may flush with every other inlet side 2 of the at least two cooling blocks 1. In at least one other embodiment it may be advantageous, that one or more inlet sides 2 of the at least two cooling blocks 1 may protrude from the other inlet sides 2. Same applies to the outlet sides 3.

Fig. 2 and Fig. 3 also show for each cooling block 1 the through hole 4a, a first additional through hole 4' and two or more additional through holes 4b, 4c, 4d.

The through hole 4a may go along a helical path and each of the two or more second additional through holes 4b, 4c, 4d may go along a respective second additional helical path through the cooling block 1. The two or more second additional through holes 4b, 4c, 4d may for example be exactly three, thus a number of helical through holes 4a, 4b, 4c, 4d per cooling block 1 may be four. The explanations here and in the following may, however, be extended to a total number of two or three or more than four helical through holes as well.

The helical through holes 4a, 4b, 4c, 4d may each wind around a fixed axis and may form an interlocking quadruple helix. This means, that each helical path and each second additional helical path may not cross each other. Each helical path and each second additional helical path may form an individual mini-channel through the cooling block 1. Each mini-channel may be separate from every other mini-channel, which means, that the cooling fluid may not be able to flow from one mini-channel to another inside the cooling block 1. Each mini-channel may be in direct contact to one or two other mini-channels, forming the interlocking quadruple helix. There may also be a certain distance between each winding of each mini-channel. This may be caused by manufacturing reasons and might be necessary for a wall stability between the mini-channels. The wall may be the material of the cooling block 1 separating one of the mini-channels from another mini-channel.

The first additional through hole 4' may for example go along a linear path, in this example shown as a straight path. In addition, the first additional through hole 4' may go along the fixed axis being surrounded by the helical through holes 4a, 4b, 4c, 4d. Further embodiments comprise the helical through holes 4a, 4b, 4c, 4d but not the first additional through hole 4'.

A geometry of each cooling block 1 of the cooling block array 7 may vary in terms of a placement, a diameter or a number of through holes 4a, 4b, 4c, 4d, 4'. The geometry may be reflectively symmetrical with respect to a plane parallel to the inlet side or to the outlet side, so that the cooling fluid may flow from the inlet side to the outlet side or vice versa.

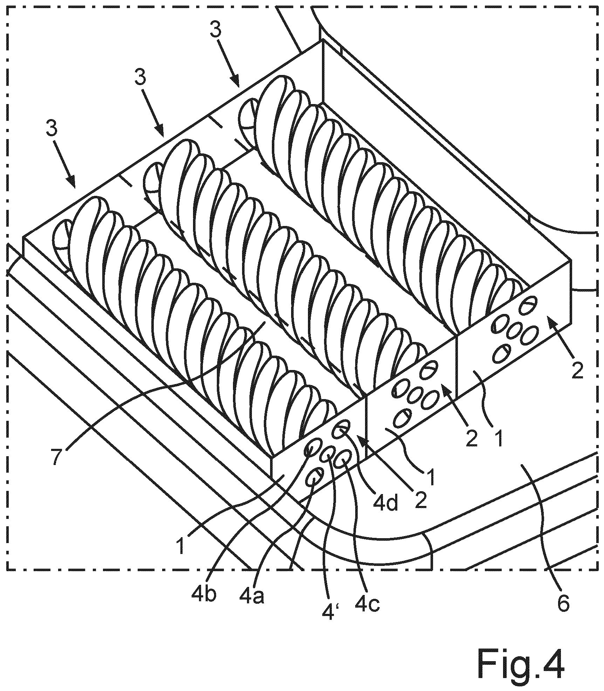

Fig. 4 shows a further embodiment of a cooling block array 7 according to the invention. The cooling block array 7 may be placed inside the cooling channel 6. For example, the cooling block array 7 may consist of three cooling blocks 1. All other descriptions of Fig. 2 and Fig. 3 may apply equally to Fig. 4.

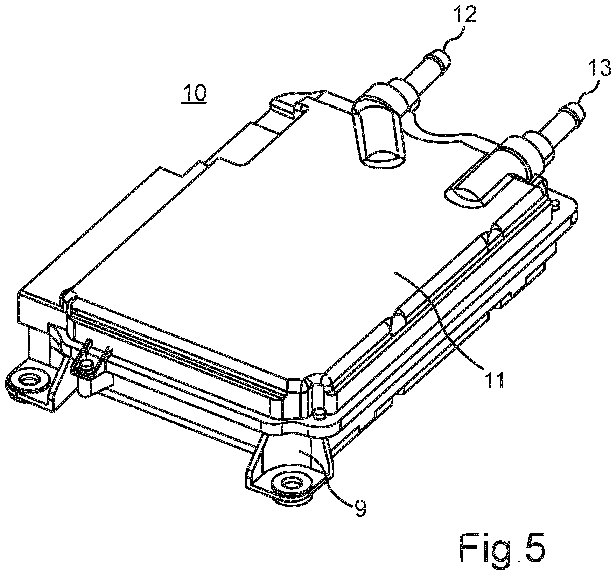

Fig. 5 shows a perspective view of an exemplary embodiment of an electronic computing device 10 according to the invention. The electronic computing device 10 may comprise a housing and an electronic component 5 (not shown). The housing may comprise an inlet connection 12, an outlet connection 13, a lower housing 9 and an upper housing 11. The housing may seal the electronic computing device 10 in a fluid tight manner expect for the inlet connection 12 and the outlet connection 13, which may be prepared to exchange cooling fluid with a transportation system for supplying the electronic computing device 10 with the cooling fluid and for draining the cooling fluid from the electronic computing device 10.

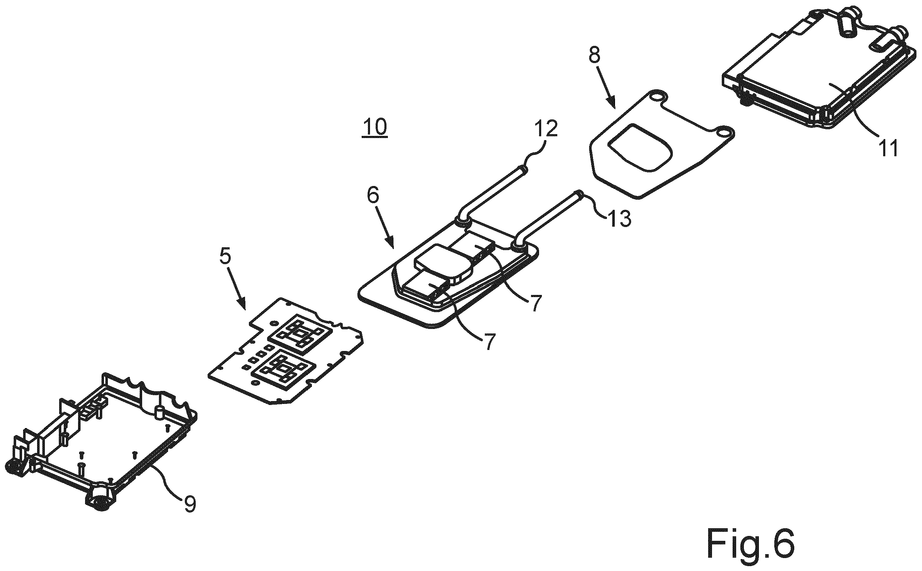

Fig. 6 shows an exploded view of the exemplary embodiment of the electronic computing device 10, which is shown in Fig. 5. Additionally the housing may comprise the cooling channel 6, the cooling block 1 and/or the cooling block array 7 and a cover 8. The cooling block 1 and/or the cooling block array 7 may be arranged within the cooling channel 6, such that the cooling fluid, which may enter the housing at the inlet connection 12, may flow through the cooling channel 6, the cooling block 1 and/or the cooling block array 7 and may exit the housing at the outlet connection 13.

The cover 8 may be prepared to be mounted on top of the cooling channel 6. If mounted the cover 8 may seal the cooling channel 6 in a fluid tight manner, such that the cooling fluid may not exit a combination of the cooling channel 6 and the cover 8 other than through the inlet connection 12 or the outlet connection 13.

The electronic component 5 may be placed on an opposite side of the cooling channel 6 in comparison to the cooling block 1, the cooling block array 7 and the cover 8. The electronic component 5 may be placed in a vicinity of the cooling block 1 or the cooling block array 7, such that a thermal contact is enabled between the electronic component 5 as a heat source and the cooling block 1 or the cooling block array 7 each as a heat sink.

The electronic component 5 and the combination of the cooling channel 6 and cover 8 may be placed between the lower housing 9 and the upper housing 11. The lower housing 9 and the upper housing 11 may be prepared to be attached to each other for example in screwed, clipped or glued manner. A combination of the lower housing 9 and the upper housing 11 may at least partially enclose the electronic component 5 and the combination of the cooling channel 6 and the cover 8.

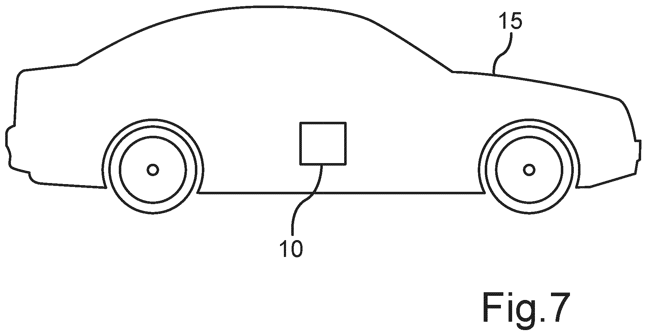

Fig. 7 shows an exemplary embodiment of a motor vehicle 15 according to the invention. The motor vehicle 15 may comprise the electronic computing device 10. The motor vehicle 15 may, for example, comprise means for recirculating or conditioning or re-cooling of the cooling fluid received by a drain from the outlet connection and provided again via a source to the inlet connection. To this end, the motor vehicle 15 may also comprise a transportation system for the cooling fluid including, for example, one or more pumps to convey the cooling fluid from the source to the inlet connection through the housing back to the outlet connection and the drain and so forth.

Within a simulation of a cooling block 1 according to the invention, a temperature of the electronic component 5, in this case a system-on-chip device, could be reduced by 16°C, when compared to a different cooling block with straight through holes. An increase of a pressure drop of the cooling block 1 according to the invention compared with the different cooling block could be limited to 10 mbar. The pressure drop describes an additionally introduced pressure loss, when placing the cooling block into the cooling channel. The pressure loss has to be overcome by the cooling fluid.

## Claims

1. Cooling block (1) for cooling an electronic component (5) of an electronic computing device (10) of a motor vehicle (15), wherein
- the cooling block (1) is applicable to a cooling channel (6) for guiding a cooling fluid; and
- the cooling block (1) comprises an inlet side (2) on a first side of the cooling block (1); and
- the cooling block (1) comprises an outlet side (3) on a second side of the cooling block (1); and
- the cooling block (1) comprises a through hole (4a, 4b, 4c, 4d, 4') connecting the inlet side (2) to the outlet side (3) of the cooling block (1); and
- the through hole (4a, 4b, 4c, 4d, 4') goes along a helical path through the cooling block (1).

2. Cooling block (1) according to claim 1, wherein an outer shape of the cooling block (1) is a cuboid shape or an essentially cuboid shape and the first side represents a first side face of the cuboid shape and the second side represents a second side face of the cuboid shape.

3. Cooling block (1) according to any one of the preceding claims, wherein the cooling block (1) comprises a first additional through hole (4a, 4b, 4c, 4d, 4') connecting the inlet side (2) to the outlet side (3) of the cooling block (1).

4. Cooling block (1) according to claim 3, wherein the first additional through hole (4a, 4b, 4c, 4d, 4') goes along a linear path through the cooling block (1) and the helical path of the through hole (4a, 4b, 4c, 4d, 4') winds around the linear path.

5. Cooling block (1) according to claim 3, wherein the first additional through hole (4a, 4b, 4c, 4d, 4') goes along a first additional helical path through the cooling block (1).

6. Cooling block (1) according to claim 5, wherein the helical path and the first additional helical path each winds around a common centerline forming an interlocking double helix.

7. Cooling block (1) according to any one of the preceding claims 1 to 4, wherein the cooling block (1) comprises two or more second additional through holes (4a, 4b, 4c, 4d, 4') each connecting the inlet side (2) to the outlet side (3) of the cooling block (1).

8. Cooling block (1) according to claim 7, wherein each of the two or more second additional through holes (4a, 4b, 4c, 4d, 4') goes along a respective second additional helical path through the cooling block (1) and the helical path and each second additional helical path wind around a common centerline, forming an interlocking multiple helix.

9. Cooling block (1) according to any one of the preceding claims, wherein the cooling block (1) comprises copper and/or copper alloy and/or aluminum and/or aluminum alloy.

10. Cooling block array (7) comprising at least two cooling blocks (1) according to any one of the preceding claims 1 to 9, wherein each respective first side of the at least two cooling blocks (1) is parallel to all other respective first sides of the at least two cooling blocks (1) and the at least two cooling blocks (1) are thermally connected to each other.

11. Electronic computing device (10) for a motor vehicle (15) comprising a housing and an electronic component (5), wherein
- the housing comprises a cooling channel (6) for guiding a cooling fluid;
- the housing comprises a cooling block (1) according to any one of the claims 1 to 9 or a cooling block array (7) according to claim 10;
- the cooling block (1) or the cooling block array (7) is located in the cooling channel (6); and
- the electronic component (5) is thermally connected to the cooling block (1) or the cooling block array (7).

12. Electronic computing device (10) according to claim 11, wherein the electronic component (5) comprises a system-on-chip and/or a system-in-package.

13. Electronic computing device (10) according to one of claims 11 or 12, wherein a thermal conductivity of the cooling block (1) and/or the cooling block array (7) is greater or at least equal to a thermal conductivity of cooling channel walls spatially limiting the cooling channel (6).

14. Electronic computing device (10) according to any one of the preceding claims 11 to 13, wherein the housing comprises a cover (8) and the cover (8) is attached to the cooling channel (6), wherein the cover (8) seals the cooling channel (6) in a fluid-tight manner and the electronic component (5) and the cooling block (1) are arranged on opposite sides of the cooling channel (6).

15. Motor vehicle (15) comprising an electronic computing device (10) according to any one of claims 11 to 14.
